# EUROPÄISCHE PATENTSCHRIFT

(11) **EP 4 148 988 B1**
(45) Veröffentlichungstag und Bekanntmachung des Hinweises auf die Patenterteilung: **01.10.2025**
(21) Anmeldenummer: 22192001.0
(22) Anmeldetag: 24.08.2022
(51) Int. Cl.: H03B 11/02, F41H 13/00, H03K 3/537

(54) **PULSGENERATOR FÜR EINEN HPEM-PULS**
PULSE GENERATOR FOR A HPEM PULSE
GÉNÉRATEUR D'IMPULSIONS POUR UNE IMPULSION HPEM

(30) Priorität: 02.09.2021 DE 102021004466
(43) Veröffentlichungstag der Anmeldung: 15.03.2023
(73) Patentinhaber: Diehl Defence GmbH & Co. KG, 88662 ÜBERLINGEN (DE)
(72) Erfinder: Kadetov, Victor, 90552 Röthenbach an der Pegnitz (DE)
(74) Vertreter: Diehl Patentabteilung

(56) Entgegenhaltungen:
- US-B1- 9 683 817
- CHO YOUNG-MAAN ET AL: "Integrated Circuit Model for Generation and Propagation of High Power Electromagnetic Pulse", JOURNAL OF THE KOREAN PHYSICAL SOCIETY, THE KOREAN PHYSICAL SOCIETY, SEOUL, vol. 72, no. 4, 18 October 2017 (2017-10-18), pages 492 - 498, XP036442861, ISSN: 0374-4884, [retrieved on 20171018], DOI: 10.3938/JKPS.72.492
- LEE J M ET AL: "Design of a damped sinusoidal oscillator system", PULSED POWER CONFERENCE (PPC), 2011 IEEE, IEEE, 19 June 2011 (2011-06-19), pages 414 - 419, XP032172844, ISBN: 978-1-4577-0629-5, DOI: 10.1109/PPC.2011.6191456

## Beschreibung

Die Erfindung betrifft die Erzeugung von HPEM-Pulsen (high power electromagnetics) durch entsprechende Pulsgeneratoren.

Aus der DE 10 2015 008 296 B4 ist eine Abwehrdrohne zur Abwehr von Kleindrohnen bekannt. Die Abwehrdrohne zur Abwehr einer Kleindrohne umfasst eine am Rumpf befestigte HPEM-Einrichtung zur Erzeugung eines hochenergetischen elektromagnetischen Pulses. Eine HPEM-Einrichtung umfasst eine Stromquelle mit einem nachgeschalteten Spannungswandler, einem Marx-Generator und einem Resonator. Die Stromquelle kann z. B. ein Akku oder eine Batterie sein. Der Spannungswandler erzeugt eine Hochspannung, wobei zwischen der Stromquelle und dem Spannungswandler ein Schalter vorgesehen ist. Der Marx-Generator ist ein Impulsgenerator, welcher mit Gleichspannung betrieben wird. Der Resonator ist z. B. ein DS-Resonator (Damped-Sinusoid Resonator), welcher eine gedämpfte Sinuswelle erzeugt.

Aus dem US-Patent 9,683,817 B1 ist die Erkennung und Sprengung von improvisierten Sprengvorrichtungen mit magnetischen Feldern bekannt. Zur Erkennung eines verdeckten Objekts ist ein magnetischer Kopplungskreis (MC) vorgesehen. Die MC-Schaltung ist mit einem Strommessgerät verbunden und umfasst eine Marx-Bank mit mehreren Stufen; eine Peaking-Schaltung; und eine Induktionsschleife.

Das Dokument CHO YOUNG-MAAN ET AL: "Integrated Circuit Model for Generation and Propagation of High Power Electromagnetic Pulse",JOURNAL OF THE KOREAN PHYSICAL SOCIETY, THE KOREAN PHYSICAL SOCIETY, SEOUL, Bd. 72, Nr. 4, 18. Oktober 2017 (2017-10-18), Seiten 492-498, offenbart einen HPEM Pulsgenerator.

Das Dokument LEE J M ET AL: "Design of a damped sinusoidal oscillator system",PULSED POWER CONFERENCE (PPC), 2011 IEEE, IEEE, 19. Juni 2011 (2011-06-19), Seiten 414-419, offenbart einen DS-Oszillator umfassend einen Marx-Generator.

Aufgabe der vorliegenden Erfindung ist es, die Erzeugung von HPEM-Pulsen zu verbessern.

Die Aufgabe wird gelöst durch einen Pulsgenerator gemäß Patentanspruch 1.

Bevorzugte oder vorteilhafte Ausführungsformen der Erfindung sowie anderer Erfindungskategorien ergeben sich aus den weiteren Ansprüchen, der nachfolgenden Beschreibung sowie den beigefügten Figuren.

Vorliegend wird also nur der Pulsgenerator einer HPEM-Einrichtung betrachtet, wie sie z. B. aus dem o.g. Stand der Technik bekannt ist. Der Pulsgenerator besteht aus demjenigen Abschnitt der HPEM-Einrichtung, der sich vom Marx-Generator bis zum DS-Resonator erstreckt. Beide sind über Zuleitungen verbunden, um die vom Marx-Generator erzeugte Marx-Spannung an den DS-Resonator weiterzuleiten. Weitere Komponenten einer HPEM-Einrichtung, wie zum Beispiel eine dem Marxgenerator vorgeschaltete Stromquelle zum Liefern der Energie für die HPEM-Pulse oder eine dem DS-Resonator nachgeschaltete Antennenanordnung zur Abstrahlung der HPEM-Pulse, werden vorliegend nicht betrachtet.

Der Pulsgenerator, auch HPEM-Quelle genannt, dient zur Erzeugung eines HPEM-Pulses, insbesondere in Form eines Spannungspulses. Der Pulsgenerator enthält einen Marx-Generator. Dieser enthält mehreren Kondensatoren, die zusammen auch als Kondensatorbank bezeichnet werden. Die Kondensatoren sind zwischen zwei Ausgangspolen des Marx-Generators in Reihe geschaltet. Der Marxgenerator ist hinsichtlich seines elektrischen Aufbaus fachüblich ausgeführt. Er enthält neben dem Ausgang also insbesondere einen Eingang zum Anschluss an eine Energieversorgung, zwei Ladeleitungen zur Verbindung der jeweiligen Kondensatorpole, Ladewiderstände / -drosseln in den Ladeleitungen, Funkenstrecken zur Entladung der Kondensatorbank usw. All diese Komponenten werden hier jedoch nicht näher betrachtet.

Beim Betrieb des Marx-Generators, insbesondere bei dessen Zündung / Entladung ist bzw. wird zwischen den Ausgangspolen eine Ausgangsspannung bereitgestellt. Die Ausgangsspannung wird auch Marxspannung genannt. Insbesondere ist der erste Ausgangspole ein Massepol, der zweite Ausgangspole ein Hochspannungspol, an dem im Betrieb die Marxspannung nach Masse als Hochspannungspotential anliegt.

Der Pulsgenerator enthält außerdem eine DS-Resonator (damped sinusoidal). Dieser weist zwei Eingangspole auf. Die Eingangspole dienen im Betrieb zum Empfangen der Ausgangsspannung bzw. Marxspannung des Marxgenerators. Beim Zünden des Pulsgenerators bzw. Marxgenerators wird dort also die Marxspannung (übertragen über die Zuleitungen, siehe unten) empfangen.

Jeder der Eingangspole ist dazu über eine jeweilige Zuleitung mit einem der Ausgangspole verbunden. Die Zuleitungen weisen eine Eigeninduktivität auf. Aufgrund der transienten Vorgänge im Pulsgenerator ist die Eingangsspannung am DS-Resonator nicht zwangsweise gleich der Ausgangsspannung an den Ausgangspolen. Vielmehr entsteht eine (C: kapazitiver Marxgenerator - L: induktive Zuleitung - C: kapazitiver DS-Resonator), welche die Energie vom Marxgenerator / Marxspannung zum DS-Resonator "pumpt" und in dessen Eingangsspannung überträgt.

Die Kondensatoren als gegenständliche Bauteile sind im Raum, also räumlich bzw. gegenständlich entlang einer Verlaufslinie angeordnet. An jedem der beiden Enden der Verlaufslinie befindet sich jeweils einer der Ausgangspole. Die "Enden" sind hierbei im weiten Sinne als eine jeweilige "Endposition" der Verlaufslinie zu verstehen. Z. B. kann hier auch gemeint sein, dass sich die Ausgangspole an einem beliebigen Ort einer Querebene zur Verlaufslinie an deren Enden befinden.

Der Abstand zwischen den Ausgangspolen ist kleiner als die Längsausdehnung des Marx-Generators entlang der Verlaufslinie. "Abstand" ist die kürzeste Strecke bzw. Gerade zwischen den beiden Ausgangspolen. Die "Längsausdehnung" ist die Länge der Verlaufslinie entlang ihres Verlaufs, der eine beliebige Form annehmen kann.

Die Verlaufslinie ist insbesondere die Linie, die die geometrischen Mittelpunkte der Kondensatoren in der Reihenfolge ihrer elektrischen Reihenschaltung miteinander verbindet. Dies kann eine Aneinanderreihung von geraden Strecken, aber auch eine Kurve, z. B. eine Spline-Kurve durch die Mittelpunkte sein. Die Verlaufslinie kann aber auch z. B. durch die jeweiligen Plus- oder Minuskontakte der Kondensatoren verlaufen. Insbesondere ist die Verlaufslinie die Linie, die eine der beiden elektrischen Ladeleitungen (eine verbindet die "Plus-", die andere die "Minuspole" der Kondensatoren) der Kondensatoren beschreibt, also eine die Kondensatoren elektrisch parallel schaltende elektrische Verbindung zwischen den Kondensatoren an Plus- und Minuskontakten.

Die Verlaufslinie beschreibt also den räumlichen, tatsächlich gegenständlichen, physikalischen Aufbau des Marx-Generators bzw. die räumliche Anordnung der Kondensatoren und bezieht sich nicht nur auf dessen elektrische Eigenschaft einer Reihenschaltung. Diese tatsächliche räumliche Anordnung weicht erfindungsgemäß von einer geraden, linearen Anordnung ab, ist also "nicht-gerade".

Die Verlaufslinie ist also nicht gerade, verläuft insbesondere gekrümmt, gebogen, geschachtelt, kurvig, gefaltet usw., je nach räumlicher Anordnung der Kondensatoren des Marxgenerators, die von einer rein linearen räumlichen Anordnung abweicht.

Die Kondensatoren sind insbesondere alle baugleich und/oder weisen gleiche Abmessungen / gleiche Anschlussgeometrie / usw. auf. Der Marx-Generator weist also in dieser Hinsicht einen regelmäßigen Aufbau einer Vielzahl von identischen bzw. gleichen bzw. sich wiederholenden Stufen / Stoßkondensatoren / Kondensatorabschnitten / usw. (einschließlich Beschaltung: Widerstände / Drosseln / Funkenstrecken / ...) auf.

Die Erfindung beruht auf der grundlegenden Idee - insbesondere für die Anwendung von HPEM gegen Drohnen -, eine Reichweitensteigerung eines herkömmlichen Systems um einen Faktor von mindestens 1,5 ohne Skalierung der Antennen zu erreichen. Eine denkbare Möglichkeit hierzu bestünde darin, die Speisung des DS-Resonators (mit der Marx-Spannung) durch einen fachüblichen "linearen" Marx-Generator höherer Spannung durchzuführen. Die Reichweitensteigerung würde also durch den Einsatz eines stärkeren (höhere Marx-Spannung) Marx-Generators sowie einer entsprechend skalierten Antenne erzielt. Der Auslegung des Marxgenerators sowie der entsprechend skalierten Antenne können in der gewünschten Skalierung jedoch sowohl physikalische als auch konstruktive Grenzen gesetzt sein, so dass diese Möglichkeit nicht praktikabel ist. Denn Marx-Generatoren werden mit höherer Spannung länger, da sie weitere Kondensatorstufen erfordern. Dadurch werden jedoch auch die von den jeweiligen Enden (Ausgangspole) zum DS-Resonator zu führenden Zuleitungen länger, so dass deren Induktivitäten steigen. Als Folge hiervon sinkt bei einer derartigen Skalierung gleichzeitig also der maximal mögliche Ladestrom.

Gemäß der Erfindung wird von der räumlich geraden Anordnung der Kondensatoren abgewichen, wodurch die Enden (Ausgangspole) der Reihenanordnung räumlich näher zueinander gelangen können. Die von den Enden (Ausgangspolen) zum DS-Resonator nötigen Zuleitungen werden dadurch kürzer. Dies ermöglicht auch insbesondere den Einbau des Resonators zusammen mit dem Marx-Generator in einem insbesondere kleineren (größte Ausdehnung) Gehäuse gegenüber der linearen Anordnung. Jedenfalls kann so die Kabelverbindung (Zuleitungen) zwischen Marx-Generator und DS-Resonator im Vergleich zu einer linearen Anordnung reduziert, insbesondere auf ein Minimum reduziert werden. Somit wird ein absolut maximaler Ladestrom vom Marx-Generator zum DS-Resonator erreicht. Um dies umsetzen zu können, wird die Marx-Kondensatorbank auf unkonventionelle Art räumlich gekrümmt, gebogen usw., insbesondere um den Resonator herum gruppiert (insbesondere annähernd ringförmig darum herum oder S-förmig - siehe unten - daneben).

Die oben genannte Option einer erhöhten Stufenzahl im Marx-Generator wird erfindungsgemäß durch ein verbessertes Überschwingen der Spannung im C-L-C Resonator-Ladekreises (Pulsgenerator) kompensiert bzw. eine gleich hohe effektive Ladespannung am DS-Resonator erzielt. Dieses Überschwingen rührt daher, dass die Funkenstrecken eine gewisse Zeit benötigen, um vollends durchzuschalten. In dieser Zeit kann die Marx-Spannung weiter ansteigen, ohne im DS-Resonator abgeführt zu werden. Durch die reduzierte Induktivität der Zuleitungen steigt die Marx-Spannung schneller an und wird höher, bevor der Durchbruch vollends stattgefunden hat.

Gemäß der Erfindung ergibt sich eine Leistungssteigerung des DS-Resonators durch schnelleres Erreichen einer Überspannung (Überschwingen der Marx-Spannung beim schnelleren Anstieg der Marx-Spannung über die eigentliche Resonatordurchbruchsspannung, da die Funkenstrecke eine gewisse Zeit zum Durchzünden bzw. vollständigen Leiten benötigt; in dieser Zeit kann die Marxspannung weiter "überhöht" werden).

Es ergibt sich eine erhöhte (Personen-)Sicherheit für den Fall, dass alle (hoch-) spannungsführenden Teile in einem einzigen zusammenhängenden Raum (Innenraum eines Gehäuses) mit Isolationsgas angeordnet werden können - siehe unten.

Es ergibt sich dabei auch eine Vermeidung von Koronaentladungen und dadurch mögliche chem. Spaltprodukte, wenn eben die spannungsführenden Teile vollständig im Isolationsgas verlaufen und nicht mit Luft in Berührung kommen.

Ein gemeinsames Gehäuse, in dem der Marx-Generator (zumindest die hochspannungsführenden Teile, insbesondere Ausgangspole) und der DS-Resonator (zumindest auch dessen hochspannungsführende Teile) - und insbesondere die Zuleitungen - untergebracht sind, kann in Metallausführung als EMV-Schutz dienen (EMV: elektromagnetische Verträglichkeit).

Der Pulsgenerator weist daher insgesamt einen geringeren Platzbedarf auf als bei Ausführung mit einem "linearen" Marx-Generator - zumindest hinsichtlich seiner größten notwendigen Ausdehnung.

Der Resonator-Ladekreis (Komponenten, die der Hochspannungsversorgung des DS-Resonators dienen), insbesondere der Marx-Generator in der nicht-geraden Raumform, ermöglicht eine kleine, insbesondere bis hin zu einer Minimallänge wählbare, insbesondere minimale Induktivität (der Zuleitungen) zwischen Marx-Generator und DS-Resonator. Dadurch steigt die Ladespannung (Marx-Spannung) des Resonators, bevor er (kurzschließt) zündet; die oben genannte Spannungsüberhöhung / Überschwingen / Überspannung. Die Felderzeugung des Resonators wird messbar gesteigert.

Die Erfindung unterscheidet sich von einer klassischen Resonatorspeisung, die mit Hilfe eines "linearen" Marxgenerators erfolgt. "Linear" ist so zu verstehen, dass die Stufen / Kondensatoren des klassischen Marxgenerators räumlich / gegenständlich in gerader Linie hintereinander in Reihenschaltung angeordnet sind. Durch die Abweichung von dieser geraden Bauform kann der Ladestrom des DS-Resonators maximiert werden. So ist eine Reichweitensteigerung eines den Pulsgenerator enthaltenden DS-Wirksystems ohne Skalierung von Reflektoren und Antennen möglich.

Vorliegend wird also eine nicht-gerade, insbesondere ringförmige Marxkonstruktion (räumliche Anordnung der Kondensatoren) für einen DS-Resonator vorgeschlagen, der eine erhöhte Überspannung am DS-Resonator erzielt.

In einer bevorzugten Ausführungsform liegt die Verlaufslinie in einer Ebene. Mit anderen Worten sind alle Kondensatoren in einer gemeinsamen Ebene angeordnet. So lassen sich besonders einfach in Reihe zu schaltende Marx-Generatoren schaffen.

In einer bevorzugten Ausführungsform folgt die Verlaufslinie einer Ringform. "Folgen" ist dabei so zu verstehen, dass die Verlaufslinie nur einen Abschnitt einer Ringform darstellt, jedoch nicht ganz ringförmig geschlossen ist, so dass ein Abstand zwischen den Enden der Verlaufslinie und damit zwischen den Ausgangspolen verbleibt. Der Abstand ist weit genug dimensioniert, um bei der bestimmungsgemäß maximalen Marx-Spannung einen Überschlag zwischen den Ausgangspolen zu vermeiden. Insbesondere folgt die Verlaufslinie der Ringform auf mindestens 95%, mindestens 90%, mindestens 85%, mindestens 80% oder mindestens 75% der Länge der Ringform (z. B. Umfang eines Kreises). Eine ringförmig verlaufende Verlaufslinie und eine entsprechende Kondensatoranordnung erlaubt es, die Ausgangspole nahe beieinander anzuordnen, um so kurze Zuleitungen zum DS-Resonator zu ermöglichen. Die Verlaufslinie ist dann insbesondere eine Rundform, Bogenform, insbesondere Kreisabschnittsform.

In einer alternativen Ausführungsform folgt die Verlaufslinie einer mindestens einfachen S-Form. Die "mindestens einfache" S-Form ist so zu verstehen, dass sich an diese S-Grundform (die zwei Kurven aufweist) auch weitere Kurven anschließen können, die letztendlich eine Schlangenform mit 2 (einfache S-Form), 3 oder mehr Bögen darstellt, wobei 3 oder mehr Bögen dann hier als "mehrfache S-Form" verstanden werden sollen. Die Aussagen zur Ringform oben gelten hier entsprechend. Dabei ist allerdings noch eine dichtere Packung der Kondensatoren aneinander möglich als bei einer Ringform, da so auch das Innere des "Rings" mit Kondensatoren gefüllt werden kann.

In einer bevorzugten Variante der oben genannten Ausführungsformen ist die Verlaufslinie eine Zick-Zack-Linie, die entlang einer Ringform oder der S-Form verläuft. Ringform und S-Form können die gleichen Formen wie oben sein. "Entlang ... verlaufen" heißt hier: Das Zick-Zack erstreckt sich also jeweils abwechselnd seitlich einer ringförmigen / S-förmigen Zentrallinie. Eine Zick-Zack-Linie ist hier im üblichen Sinne zu verstehen, nämlich als Aneinanderreihung von sich jeweils abwechselnd mit spitzen Winkeln aneinander anschließenden Geradenstücken. Insbesondere sind die Geradenstücke gleich lang. Mit anderen Worten ist die Verlaufslinie wie folgt erzeugt: zunächst wird eine Zickzacklinie entlang einer Erstreckungs-Geraden erzeugt. Bei dieser Zick-Zack-Linie sind insbesondere alle Geradenstücke gleich lang und alle Winkel zwischen den jeweiligen Geradenstücken gleich. Sodann wird diese Erstreckungs-Gerade zur Ringform oder S-Form gebogen, wobei die Zick-Zack-Linie entsprechend mit gebogen oder verformt wird, ihre Zick-Zack-Struktur aber beibehält. Die jeweiligen Geraden-Abschnitte der Zickzacklinie verbleiben auch in der gebogenen oder verformten Form Geradenabschnitte; nur die Winkel verändern sich.

Auch so lässt sich eine räumlich besonders dicht gepackte Kondensatoranordnung schaffen.

In einer bevorzugten Ausführungsform verläuft die Verlaufslinie zumindest teilweise um den DS-Resonator herum. Insbesondere ist die Verlaufslinie dabei die Ringform oder eine "ringförmige" - also wie oben erläutert ringförmig gebogene - Zick-Zack-Linie. Insbesondere befindet sich der DS-Resonator zentral innerhalb der Ringform. Die Ringform ist insbesondere eine Kreisform, die konzentrisch zum DS-Resonator liegt. Somit ergibt sich ein besonders dicht gepackter Pulsgenerator mit im Wesentlichen symmetrischer Anordnung.

In einer alternativen Ausführungsform verläuft die Verlaufslinie neben dem DS-Resonator, wobei die Verlaufslinie mit ihren Enden an den DS-Resonator angrenzt. Damit grenzen auch die Ausgangspole, die sich - wie oben erläutert - an den Enden der Verlaufslinie befinden, an den DS-Resonator an. Insbesondere befinden sich also keine Abschnitte der Verlaufslinie zwischen deren Enden und dem DS-Resonator. Im Ergebnis können so besonders kurze Zuleitungen von den Ausgangspolen zum DS-Resonator bzw. dessen Eingangspolen realisiert werden. Die Verlaufslinie ist hierbei insbesondere die oben genannte S-Form. Insbesondere ist der DS-Resonator neben der, der oben genannten S-Form folgenden, Kondensatorbank angeordnet.

In einer bevorzugten Ausführungsform erstreckt sich der DS-Resonator hinsichtlich seiner Form (räumliche Form, insbesondere Grundform, Außenform, Grobform, Gestalt, ...) entlang einer Längsachse und die Kondensatoren erstrecken sich zwischen ihren beiden jeweiligen Plus- und Minuskontakten parallel zur Längsachse. Gemeint ist also, dass die Verbindungslinie zwischen Plus- und Minuskontakt parallel zur Längsachse verläuft.

Hinsichtlich des DS-Resonators ist hierbei also insbesondere dessen Gehäusegrundform angesprochen, die insbesondere eine gerade Kreiszylinderform ist. Hinsichtlich der Kondensatoren ist insbesondere deren Erstreckung von deren einem zu deren anderem Pol ("+"- und "-"-Pol) angesprochen. Jedoch können auch die Kondensatoren hinsichtlich ihrer Außenform angesprochen sein, die ebenfalls eine gerade Kreiszylinderform sein kann. In dieser Ausführungsform kann ein insgesamt räumlich besonders dicht gepackter Pulsgenerator geschaffen werden.

In einer bevorzugten Ausführungsform ist der Marx-Generator zumindest bezüglich seiner Ausgangspole und der DS-Resonator zumindest bezüglich seiner Eingangspole und die gesamten Zuleitungen innerhalb eines gemeinsamen Gehäuses (in dessen Innenraum) untergebracht. Das Gehäuse ist insbesondere geschlossen, weist also keine Lücken auf (Durchführungen etc. für Leitungen usw. ausgenommen). Der Pulsgenerator weist also ein entsprechendes Gehäuse auf. Insbesondere ist der gesamte Resonator, und nicht nur dessen Eingangspole, und/oder auch der gesamte Marxgenerator bzw. dessen Kondensatoren, und nicht nur dessen Ausgangspole, innerhalb des Gehäuses untergebracht. Somit sind zumindest die gesamten hochspannungsführenden Teile oder auch sämtliche Komponenten des Pulsgenerators eingehaust und somit geschützt untergebracht. Dies bedeutet auch, dass im Außenraum (außerhalb des Gehäuses) befindliche Personen durch das Gehäuse vor den Komponenten im Innenraum des Gehäuses bzw. dem gesamten Pulsgenerator geschützt sind.

In einer bevorzugten Variante dieser Ausführungsform ist der Marx-Generator vollständig innerhalb des Gehäuses untergebracht. Der DS-Resonator ist jedoch nur mit einem die Eingänge aufweisenden Abschnitt innerhalb des Gehäuses untergebracht. Ein restlicher Abschnitt des DS Resonator befindet sich außerhalb des Gehäuses. So kann das Gehäuse möglichst klein gehalten werden, ohne die oben genannten Schutzaspekte zu verlieren.

In einer bevorzugten Variante dieser Ausführungsformen ist das Gehäuse ein elektrisch leitfähiges, insbesondere Metall-, Gehäuse. Hierdurch kann das Gehäuse unter anderem als EMV-Schutz für die innerhalb liegenden Komponenten genutzt werden.

In einer bevorzugten Variante der oben genannten Ausführungsformen ist das Gehäuse mit einem Isolationsgas gefüllt. Ein elektrischer Durchschlag zwischen Komponenten unterschiedlicher Spannungspotenziale ist hierdurch erschwert; insbesondere können Funkenstrecken für die gleiche Durchbruchsspannung kleiner dimensioniert werden, wodurch die Baugröße des gesamten Pulsgenerators reduziert werden kann.

Weitere Merkmale, Wirkungen und Vorteile der Erfindung ergeben sich aus der nachfolgenden Beschreibung eines bevorzugten Ausführungsbeispiels der Erfindung sowie der beigefügten Figuren. Dabei zeigen, jeweils in einer schematischen Prinzipskizze:
- Figur 1: einen Pulsgenerator mit Marx-Generator nach dem Stand der Technik in einer Prinzipdarstellung,
- Figur 2: einen erfindungsgemäßen Pulsgenerator mit ringförmig um einen DS-Resonator angeordneter Kondensatorbank in perspektivischer Ansicht,
- Figur 3: den Pulsgenerator aus Fig. 2 in Draufsicht,
- Figur 4: eine Draufsicht gemäß Fig. 3 auf einen alternativen Pulsgenerator mit mehrfach S-förmig angeordneter Kondensatorbank,
- Figur 5: eine Draufsicht gemäß Fig. 3 auf einen alternativen Pulsgenerator mit Zick-Zack-förmig angeordneter Kondensatorbank,
- Figur 6: einen Verlauf von Marx-Spannungen und Resonator-Ladespannungen über der Zeit,
- Figur 7: mit dem HPEM-Puls erreichbare Feldamplituden über der Marx-Spannung für verschiedene Pulsgeneratoren bzw. Ladekreise.

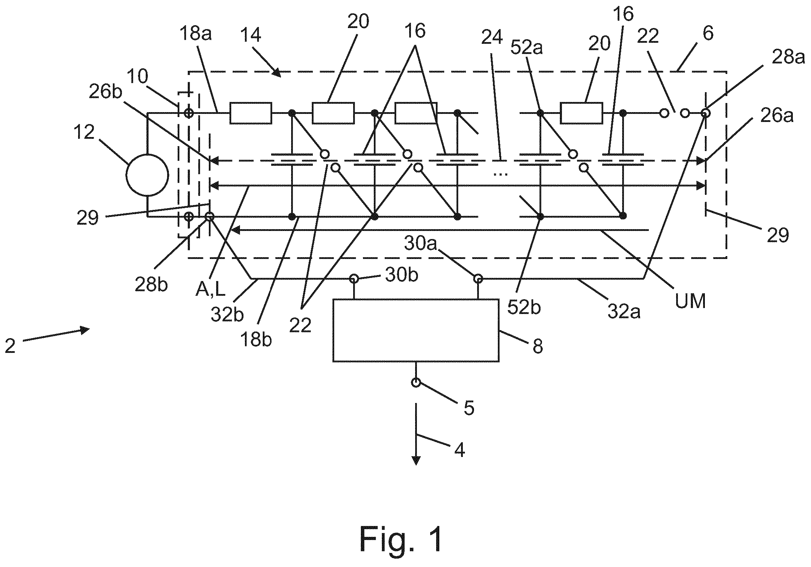

Figur 1 zeigt einen Pulsgenerator 2 zur Erzeugung eines HPEM-Pulses 4 bzw. des hierzu nötigen Spannungspulses / Energiepulses, der hier symbolisch als Pfeil angedeutet ist. Der Pulsgenerator 2 wird an einem nicht näher erläuterten Eingang 10 des Marx-Generators 6 sowie des Pulsgenerators 2 mit einer Ladespannung 12 versorgt. Der HPEM-Puls 4 wird an einem Ausgang 5 erzeugt und einer hier nicht dargestellten Antennenanordnung zugeführt, um von dieser gerichtet abgestrahlt zu werden. Die Abstrahlung dient zum Beispiel der Bekämpfung von nicht dargestellten Drohnen mittels HPEM.

Der Pulsgenerator 2 enthält einen Marx Generator 6 sowie einen DS-Resonator 8. Der Marxgenerator 6 weist den Eingang 10 in fachüblicher Weise auf bzw. ist von diesem versorgt. Der Marx Generator 6 enthält eine Kondensatorbank 14 mit einer Mehrzahl von Kondensatoren 16, von denen in Figur 1 exemplarisch nur fünf Stück dargestellt sind. Die Kondensatoren 16 sind in fachüblicher Weise in Reihe geschaltet und hierzu unter anderem zwischen zwei Ladeleitungen 18a,b angeschlossen, die von der Ladespannung 12 versorgt werden. Der Marx Generator 6 enthält in fachüblicher Weise Ladewiderstände 20 in der Ladeleitungen 18a sowie Funkenstrecken 22 - sowohl zwischen den einzelnen Kondensatoren 16 als auch ausgangsseitig - die hier nicht näher erläutert werden sollen.

Die Kondensatoren 16 sind räumlicher bzw. gegenständlicher Hinsicht entlang einer Verlaufslinie 24 angeordnet. Die Verlaufslinie 24 weist zwei Enden 26a,b auf. An diesen Enden 26a,b der Verlaufslinie 24 sind zwei Ausgangspole 28a,b des Marxgenerators 6 angeordnet. Die Anordnung "am Ende" bedeutet hierbei, dass sich die Ausgangspole in einer jeweiligen Querebene 29 (senkrecht zur Papierebene) zur Verlaufslinie 24 am Ort des jeweiligen Endes 26a,b befinden.

In dieser räumlichen bzw. gegenständlichen Hinsicht ist der Marxgenerator 6 in Figur 1 nach dem Stand der Technik aufgebaut: Die Verlaufslinie 24 ist hier eine Gerade. Die derartige räumliche Anordnung der Kondensatoren 16 ist im Stand der Technik üblich.

Im Betrieb des Marxgenerators 6 wird (nach Aufladen der Kondensatorbank 14 und beim bzw. nach Durchbruch der Funkenstrecken 22) zwischen den Ausgangspolen 28a,b eine Ausgangsspannung des Marxgenerators 6, nämlich die Marxspannung UM bereitgestellt.

Der DS-Resonator 8 weist zwei Eingangspole 30a,b auf, die im Betrieb mit der Marxspannung UM versorgt werden. Daher sind die Eingangspole 30a,b über jeweils eine elektrische Zuleitung 32a,b mit den Ausgangspolen 28a,b verbunden. Anhand der Versorgung durch die Marxspannung UM erzeugt der DS-Resonator 8 im Betrieb an seinem Ausgang 5 - der auch den Ausgang 5 des Pulsgenerators 2 darstellt - den HPEM-Puls 4. Gemäß der bekannten räumlichen linearen Anordnung der Kondensatoren 16 bzw. da die Verlaufslinie 24 eine Gerade ist, entspricht der Abstand A zwischen den Ausgangspolen 28a,b hier der Länge der Verlaufslinie 24, die der Längsausdehnung L des Marxgenerators 6 entlang dieser Verlaufslinie 24 entspricht.

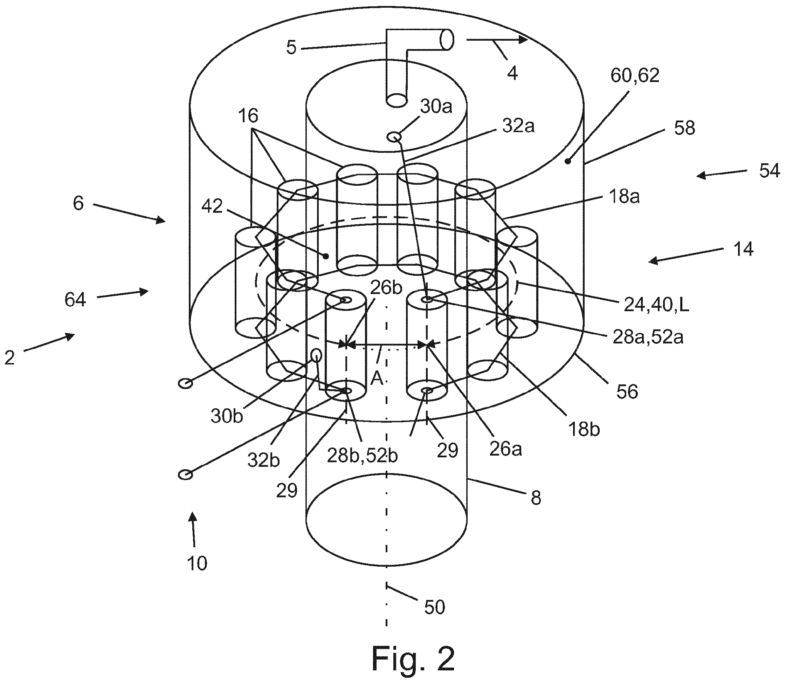

Figur 2 zeigt einen Pulsgenerator 2 gemäß der Erfindung in perspektivischer Ansicht.

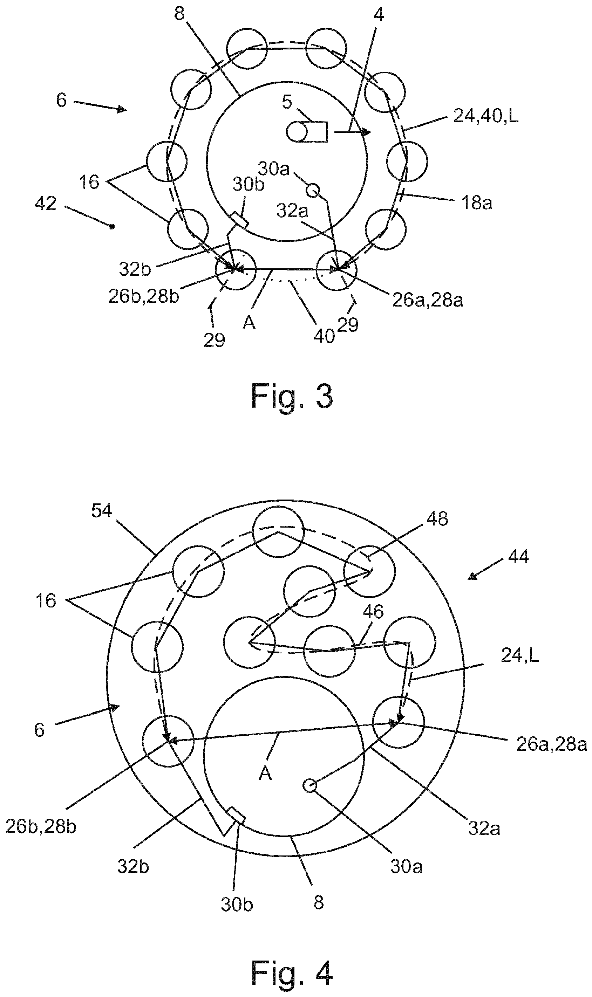

Figur 3 zeigt den Pulsgenerator 2 aus Figur 2 in Draufsicht in Richtung des Pfeils III.

Elektrischer Aufbau und Verschaltung des Pulsgenerators 2 der Figuren 3 und 4 entsprechen demjenigen aus Figur 1. Gemäß der Erfindung ist jedoch die Verlaufslinie 24 keine Gerade, sondern folgt einer Ringform 40, die hier eine Kreisform ist (gepunktete Fortsetzung bzw. Ergänzung der gestrichelten Verlaufslinie). "Der Ringform 40 folgen" ist hierbei so zu verstehen, dass die Verlaufslinie 24 keinen vollständigen geschlossenen Ring, hier Kreis, sondern lediglich ein Ring- / Kreissegment bildet, so dass ein Abstand A zwischen den Enden 26a,b bzw. Querebenen 29 der Verlaufslinie 24 und somit zwischen den Ausgangspolen 28a,b des Marx-Generators 6 verbleibt.

Wegen der ringförmigen Anordnung der Kondensatorbank 14 rücken die Enden 26a,b und damit die Ausgangspole 28a,b näher zusammen als bei einer geraden Anordnung nach Figur 1. Daher ist nun der Abstand A zwischen den Ausgangspolen 28a,b kleiner als die Längsausdehnung L des Marxgenerators 6 entlang der Verlaufslinie 24, also der Länge (hier durch einen Doppelpfeil nochmals symbolisiert) der Verlaufslinie 24 entlang der Ringform 40 bzw. Kreisform.

Die Verlaufslinie 24 liegt hier in einer Ebene 42, die in Figur 3 der Papierebene entspricht. Die Verlaufslinie 24 verläuft hier außerdem (bis auf den "Spalt", der dem Abstand A entspricht) um den DS-Resonator 8 herum.

Der DS-Resonator 8 erstreckt sich hinsichtlich seiner räumlichen Form entlang einer Längsachse 50. Ebenfalls hinsichtlich ihrer räumlichen Form erstrecken sich die jeweiligen Kondensatoren 16, die hier alle gleich geformt sind, zwischen ihren jeweiligen Pluskontakten 52a und Minuskontakten 52b jeweils parallel zur Längsachse 50. Die Ringform 40 verläuft konzentrisch zur Längsachse 50, die Ebene 42 ist eine Querebene der Längsachse 50. Die Kondensatorbank 14 ist also konzentrisch zum DS-Resonator 8 angeordnet.

Der Pulsgenerator 2 weist ein Gehäuse 54 auf. Dieses enthält einen hier kreisförmigen Gehäuseboden 56 sowie einen hier zylinderförmigen Deckel 58. Insgesamt umschließt das Gehäuse 54 einen Innenraum 60, welcher hier mit einem Isolationsgas 62 gefüllt ist. Das Gehäuse 54 ist hier aus einem metallischen, elektrisch leitfähigen Material gefertigt.

Vorliegend ist der gesamte Marxgenerator 6 und daher auch dessen Ausgangspole 28a,b innerhalb des Gehäuses 54, also im Innenraum 60 und somit dem Isolationsgas 62 angeordnet. Der DS-Resonator 8 ist zumindest so weit, nämlich mit seinem die Eingangspole 30a,b aufweisenden Abschnitt 64 im Innenraum 60 angeordnet, so dass dessen Eingangspole 30a,b im Isolierglas 62 liegen. Die Zuleitungen 32a,b verlaufen vollständig im Innenraum 60 und somit dem Isolationsgas 62. Sämtliche Komponenten des Pulsgenerators 2, welche also im Betrieb die Marxspannung UM führen, liegen innerhalb des Isolationsgases 62 und auch innerhalb des Gehäuses 54. Ein Ionisieren von Luft sowie ein nicht gewünschter Überschlag zwischen diesen Komponenten ist somit durch das Isolationsgas 62 unterbunden bzw. die Gefahr hierfür minimiert.

Das metallische Gehäuse 54 dient außerdem dem Schutz von Personen, welche den Pulsgenerator 2 handhaben sowie der elektromagnetischen Abschirmung zwischen Innenraum 60 und dem das Gehäuse 54 umgebenden Außenraum.

Figur 4 zeigt in einer Draufsicht gemäß Figur 3 einen alternativen Pulsgenerator 2 bzw. Marx Generator 6 gemäß der Erfindung. Im Unterschied zu oben ist hier die Verlaufslinie 24 keine Ring- bzw. Kreisform, sondern eine "mehrfache", hier zweifache S-Form 44, was bedeutet, dass sich an die einfache S-Form 46 ein weiterer Bogen 48 - wieder in Gegenrichtung gekrümmt - anschließt. Auch hier ist der Abstand A zwischen den Enden 26a,b wiederum kleiner als die Längsausdehnung L des Marxgenerators 6 entlang der Verlaufslinie 24 (ebenfalls zwischen deren Enden 26a,b).

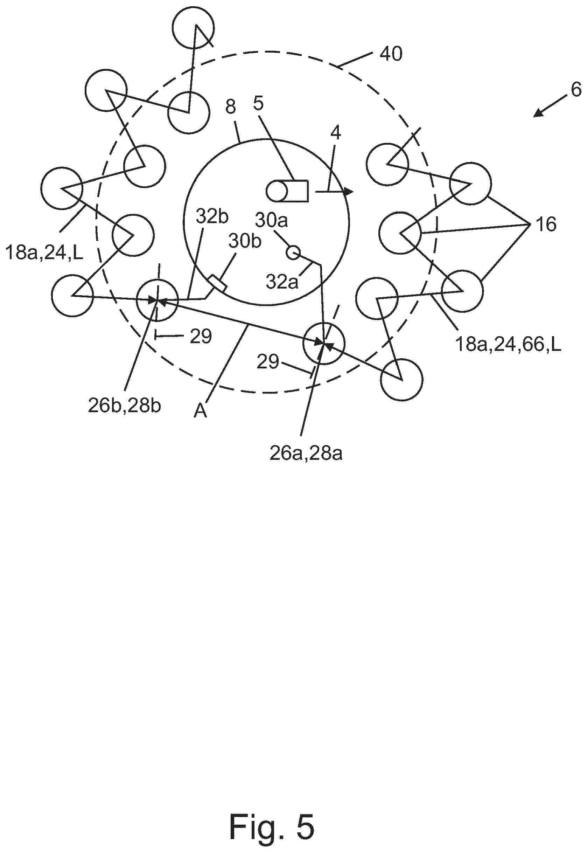

Figur 5 zeigt in einer Draufsicht gemäß Figur 3 einen nochmals alternativen Pulsgenerator 2 bzw. Marx-Generator 6 gemäß der Erfindung. Ein Teil der Kondensatoren 16 der Kondensatorbank 14 sind der Übersichtlichkeit halber nicht dargestellt. Im Unterschied zu oben existiert hier zwar ebenfalls wieder eine gestrichelt angedeutete Ring- bzw. Kreisform; die Verlaufslinie 24 ist hier jedoch eine Zick-Zack-Linie 66, die der Ring- bzw. Kreisform folgt, also ausgehend von einer (nicht dargestellten) gerade verlaufenden Zick-Zack-Linie auf die Kreisform hin gebogen ist. Auch hier ist der Abstand A zwischen den Enden 26a,b wiederum kleiner als die Längsausdehnung L des Marxgenerators 6 entlang der Verlaufslinie 24 (ebenfalls zwischen deren Enden 26a,b).

In den Figuren 4 und 5 verläuft die Verlaufslinie 24 jeweils neben dem DS-Resonator 8; sie grenzt jedoch mit ihren jeweiligen Enden 26a,b an den DS-Resonator 8 an.

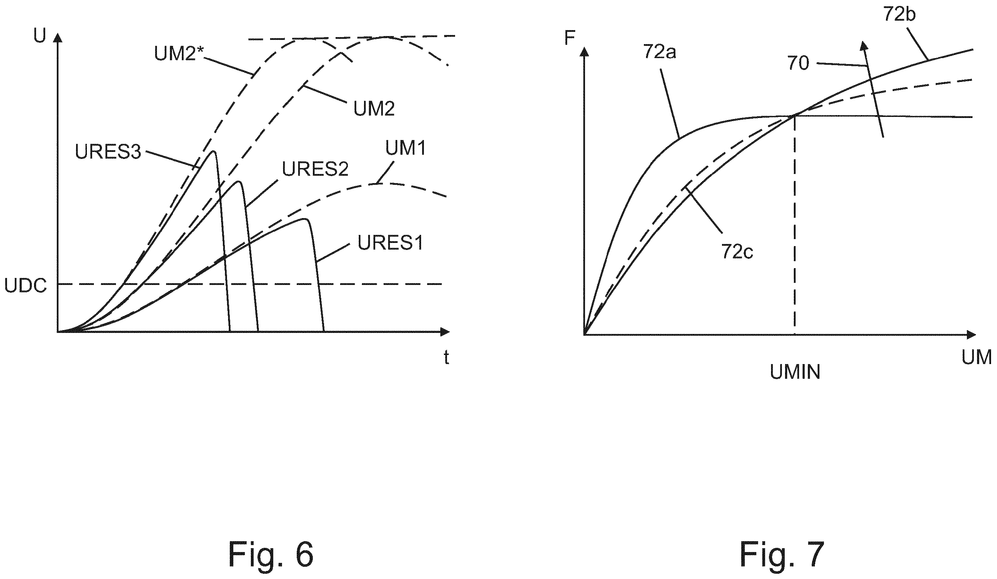

Figur 6 veranschaulicht qualitativ die in einem DS-Resonator 8 bzw. an dessen Eingangspolen 30a,b generell erreichbare Eingangsspannung URES, die je nach Höhe der grundlegenden Marxspannung UM1,2 (unterschiedlich leistungsfähige Marxgeneratoren 6) höher oder niedriger ausfällt. Denn strenggenommen sind wegen der transienten Vorgänge die Spannungen zwischen den Eingangspolen 30a,b und den Ausgangspolen 28a,b verschieden, auch wenn hier der Einfachheit halber in der Regel von einer einzigen "Marxspannung" gesprochen wird.

Dargestellt ist der Verlauf zweier verschiedener Marx-Spannungen UM1 und UM2 und der damit erreichbaren Eingangsspannungen URES1,2 am DS-Resonator 8 über der Zeit t.

Grundlage hierfür ist die Überhöhung über der quasistatisch erreichbaren Eingangsspannung UDC (Durchbruch der Funkenstrecken bei quasi statischer Spannungserhöhung). Dabei wird der Effekt ausgenutzt, dass der Durchbruch der Funkenstrecken 22 eine gewisse Zeit benötigt, in welcher die Marxspannung UM weiter ansteigen kann. Die genannte Überhöhung ist auch als semi-empirisches "Spannungs- Zeit-Flächen-Gesetz" von Kind aus dem Jahre 1957 bekannt.

Die Erfindung beruht nun auf der Erkenntnis, dass durch eine Reduktion der Induktivitäten der Zuleitungen 32a,b auch bei gleichbleibender Marxspannung (z. B. UM2) eine höhere Eingangsspannung am Resonator URES3 gegenüber URES2 erreicht werden kann, da ein schnellerer Spannungsanstieg der Marxspannung UM2* erfolgt, die Funkenstrecken 22 jedoch nach wie vor eine gewisse Zeit zum Durchbrechen benötigen.

Figur 7 veranschaulicht qualitativ diesen Zusammenhang nochmals: Es sind die Feldamplituden F von HPEM-Pulsen 4 (nach der Abstrahlung durch eine Antenne) dargestellt. Jede Kurve entspricht einem anderen Pulsgenerator 2, wobei sich diese alleine durch die Induktivitäten ihrer Zuleitungen 32a,b unterscheiden. Die Induktivitäten nehmen in Richtung des Pfeils 70 ab. Aufgetragen sind die Kurven über der zur Verfügung stehenden Marxspannung UM. Die Kurve 72a entspricht dabei einem aus der Praxis bekannten Marxgenerator nach Figur 1 mit Verlaufslinie 24 in Form einer Geraden, sogenannter CLC-Kreis, (C: Kondensatorbank 14 / L: Zuleitungen 32a,b) / C: DS-Resonator 6). Die Kurve 72b entspricht einem Pulsgenerator zwei mit idealen Zuleitungen 32a,b, die Induktivitäten von Null aufweisen. Dabei ergibt sich ein C-C-Ladekreis, der jedoch keine Resonanz-Pumpeigenschaft zwischen den beiden Kapazitäten aufweist, sodass mit einer bestimmten Ladung beider Kondensatoren (Marx-Generator 6 und DS-Resonator 8) nur die halbe Spannung erzeugbar ist. Die Kurve 72c entspricht der Erfindung; durch Absenken der Induktivitäten der Zuleitungen 32a,b kann ab einer bestimmten minimalen Marxspannung, Minimalspannung UMIN damit eine erfindungsgemäß höhere Feldamplitude erreicht werden, obschon der Marx-Generator 6 hinsichtlich seiner erreichbaren Marx-Spannung UM nicht höher ausgelegt werden muss.

Bei moderaten Marxspannungen UM (kleiner UMIN) ist also der C-L-C-Ladekreis effektiv, der C-C- Ladekreis ist bis zum Faktor zwei nicht effektiv. Bei höheren Resonator-Überspannungen (UM größer UMIN) ergibt sich eine erhöhte Effizienz des erfindungsgemäßen Pulsgenerators 2 mit nicht-gerader Verlaufslinie 24, insbesondere Ringform 40 / S-Form 44 / Zick-Zack-Linie 66, gegenüber dem aus der Praxis bekannten Marxgenerator mit Verlaufslinie 24 in Form einer Geraden.

### Bezugszeichenliste

- 2: Pulsgenerator
- 4: HPEM-Puls
- 5: Ausgang (HPEM-Puls)
- 6: Marx-Generator
- 8: DS-Resonator
- 10: Eingang
- 12: Ladespannung
- 14: Kondensatorbank
- 16: Kondensator
- 18a,b: Ladeleitung
- 20: Ladewiderstand
- 22: Funkenstrecke
- 24: Verlaufslinie
- 26a,b: Ende
- 28a,b: Ausgangspolen
- 29: Querebene
- 30a,b: Eingangspol
- 32a,b: Zuleitung
- 40: Ringform
- 42: Ebene
- 44: S-Form (mehrfach)
- 46: S-Form (einfach)
- 48: Bogen
- 50: Längsachse (DS-Resonator)
- 52a,b: Plus- / Minuskontakt
- 54: Gehäuse
- 56: Gehäuseboden
- 58: Deckel
- 60: Innenraum
- 62: Isolationsgas
- 66: Zick-Zack-Linie
- 64: Abschnitt (DS-Resonator)
- 70: Pfeil
- 72a-c: Kurve

- UM,UM1,2: Marxspannung
- A: Abstand (Ausgangspole)
- L: Längsausdehnung (Marxgenerator)
- URES1,2: Eingangsspannung (DS-Resonator)
- UDC: Eingangsspannung (quasistatischer Fall)
- UMIN: Minimalspannung
- t: Zeit
- F: Feldamplitude
- U: Spannung

## Patentansprüche

1. Pulsgenerator (2) zur Erzeugung eines HPEM-Pulses (4),
- mit einem Marx-Generator (6) mit mehreren Kondensatoren (16), die zwischen zwei Ausgangspolen (28a,b) in Reihe geschaltet sind, wobei beim Betrieb des Marx-Generators (6) zwischen den Ausgangspolen (28a,b) eine Marxspannung (UM) bereitgestellt ist,
- mit einem DS-Resonator (8), Damped-Sinusoid Resonator, mit zwei Eingangspolen (30a,b), wobei jeder der Eingangspole (30a,b) über eine jeweilige Zuleitung (32a,b) mit einem der Ausgangspole (28a,b) verbunden ist,
- wobei die Kondensatoren (16) räumlich entlang einer Verlaufslinie (24) angeordnet sind, an deren beiden Enden (26a,b) sich jeweils einer der Ausgangspole (28a,b) befindet, und die Ausgangspole (28a,b) die Enden der Reihenanordnung der Kondensatoren (16) sind; **dadurch gekennzeichnet, dass** der Abstand (A) zwischen den Ausgangspolen (28a,b) kleiner als die Längsausdehnung (L) des Marx-Generators (6) entlang der Verlaufslinie (24) ist, wobei die Längsausdehnung (L) die Länge der Verlaufslinie (24) entlang ihres Verlaufes ist.

2. Pulsgenerator (2) nach Anspruch 1,
**dadurch gekennzeichnet,**
**dass** die Verlaufslinie (24) in einer Ebene (42) liegt.

3. Pulsgenerator (2) nach einem der Ansprüche 1 bis 2,
**dadurch gekennzeichnet,**
**dass** die Verlaufslinie (24) einer Ringform (40) folgt.

4. Pulsgenerator (2) nach einem der Ansprüche 1 bis 2,
**dadurch gekennzeichnet,**
**dass** die Verlaufslinie (24) einer mindestens einfach-S-Form (44) folgt.

5. Pulsgenerator (2) nach einem der Ansprüche 3 oder 4,
**dadurch gekennzeichnet,**
**dass** die Verlaufslinie (24) eine Zick-Zack-Linie (66) ist, die entlang einer Ringform (40) oder S-Form (44) verläuft.

6. Pulsgenerator (2) nach einem der Ansprüche 1 bis 5,
**dadurch gekennzeichnet,**
**dass** die Verlaufslinie (24) zumindest teilweise um den DS-Resonator (8) herum verläuft.

7. Pulsgenerator (2) nach einem der Ansprüche 1 bis 5,
**dadurch gekennzeichnet,**
**dass** die Verlaufslinie (24) neben dem DS-Resonator (8) verläuft, wobei die Verlaufslinie (24) mit ihren Enden (26a,b) an den DS-Resonator (8) angrenzt.

8. Pulsgenerator (2) nach einem der vorhergehenden Ansprüche,
**dadurch gekennzeichnet,**
**dass** sich der DS-Resonator (8) hinsichtlich seiner Form entlang einer Längsachse (50) erstreckt und sich die Kondensatoren (16) zwischen ihren beiden jeweiligen Pluskontakten (52a) und Minuskontakten (52b) parallel zur Längsachse (50) erstrecken.

9. Pulsgenerator (2) nach einem der vorhergehenden Ansprüche,
**dadurch gekennzeichnet,**
**dass** der Pulsgenerator (2) ein Gehäuse (54) aufweist und der Marx-Generator (6) zumindest bezüglich seiner Ausgangspole (28a,b) und der DS-Resonator (8) zumindest bezüglich seiner Eingangspole (30a,b) und die gesamten Zuleitungen (32a,b) innerhalb des gemeinsamen Gehäuses (54) untergebracht.

10. Pulsgenerator (2) nach Anspruch 9,
**dadurch gekennzeichnet,**
**dass** der Marx-Generator (6) vollständig, der DS-Resonator (8) jedoch nur mit einem die Eingänge (30a,b) aufweisenden Abschnitt (64) innerhalb des Gehäuses (54) untergebracht ist.

11. Pulsgenerator (2) nach einem der Ansprüche 9 bis 10,
**dadurch gekennzeichnet,**
**dass** das Gehäuse (54) ein elektrisch leitfähiges Gehäuse ist.

12. Pulsgenerator (2) nach einem der Ansprüche 9 bis 11,
**dadurch gekennzeichnet,**
**dass** das Gehäuse (54) mit einem Isolationsgas (62) gefüllt ist.

## Claims

1. Pulse generator (2) for generating an HPEM pulse (4),
- having a Marx generator (6) having a plurality of capacitors (16) that are connected in series between two output poles (28a,b), wherein a Marx voltage (UM) is provided between the output poles (28a,b) during operation of the Marx generator (6),
- having a DS resonator (8), damped sinusoid resonator, having two input poles (30a,b), wherein each of the input poles (30a,b) is connected to one of the output poles (28a,b) via a respective supply line (32a,b),
- wherein the capacitors (16) are spatially arranged along a profile line (24) at the two ends (26a,b) of which a respective one of the output poles (28a,b) is located, and the output poles (28a,b) are the ends of the series arrangement of the capacitors (16); **characterized in that** the distance (A) between the output poles (28a,b) is smaller than the longitudinal extent (L) of the Marx generator (6) along the profile line (24), wherein the longitudinal extent (L) is the length of the profile line (24) along the profile thereof.

2. Pulse generator (2) according to Claim 1,
**characterized in that**
the profile line (24) lies in a plane (42).

3. Pulse generator (2) according to either one of Claims 1 to 2,
**characterized in that**
the profile line (24) follows a ring shape (40).

4. Pulse generator (2) according to either one of Claims 1 to 2,
**characterized in that**
the profile line (24) follows an at least single S shape (44).

5. Pulse generator (2) according to either one of Claims 3 and 4,
**characterized in that**
the profile line (24) is a zigzag line (66) that runs along a ring shape (40) or S shape (44).

6. Pulse generator (2) according to any one of Claims 1 to 5,
**characterized in that**
the profile line (24) runs at least in part around the DS resonator (8).

7. Pulse generator (2) according to any one of Claims 1 to 5,
**characterized in that**
the profile line (24) runs alongside the DS resonator (8), wherein the profile line (24) adjoins the DS resonator (8) by way of the ends (26a,b) of the profile line.

8. Pulse generator (2) according to any one of the preceding claims,
**characterized in that**
the DS resonator (8) extends in terms of its shape along a longitudinal axis (50) and the capacitors (16) extend in parallel with the longitudinal axis (50) between the two respective positive contacts (52a) and negative contacts (52b) of said capacitors.

9. Pulse generator (2) according to any one of the preceding claims,
**characterized in that**
the pulse generator (2) has a housing (54), and the Marx generator (6) at least with respect to the output poles (28a,b) thereof and the DS resonator (8) at least with respect to the input poles (30a,b) thereof and all of the supply lines (32a,b) are accommodated within the joint housing (54).

10. Pulse generator (2) according to Claim 9,
**characterized in that**
the Marx generator (6) is accommodated fully within the housing (54), but only a section (64) of the DS resonator (8) that comprises the inputs (30a,b) is accommodated within the housing.

11. Pulse generator (2) according to either one of Claims 9 to 10,
**characterized in that**
the housing (54) is an electrically conductive housing.

12. Pulse generator (2) according to any one of Claims 9 to 11,
**characterized in that**
the housing (54) is filled with an insulation gas (62).

## Revendications

1. Générateur d'impulsions (2) destiné à générer une impulsion HPEM (4),
- comprenant un générateur de Marx (6) doté de plusieurs condensateurs (16) qui sont connectés en série entre deux pôles de sortie (28a, b), une tension de Marx (UM) étant fournie entre les pôles de sortie (28a, b) lors du fonctionnement du générateur de Marx (6),
- comprenant un résonateur DS (8), ou Damped-Sinusoid Resonator, doté de deux pôles d'entrée (30a, b), chacun des pôles d'entrée (30a, b) étant connecté à l'un des pôles de sortie (28a, b) par l'intermédiaire d'une ligne d'alimentation respective (32a, b),
- les condensateurs (16) étant agencés spatialement le long d'une ligne de parcours (24), aux deux extrémités (26a, b) de laquelle se trouve respectivement l'un des pôles de sortie (28a, b), et les pôles de sortie (28a, b) étant les extrémités de l'agencement en série des condensateurs (16) ; **caractérisé en ce que** la distance (A) entre les pôles de sortie (28a, b) est inférieure à l'extension longitudinale (L) du générateur de Marx (6) le long de la ligne de parcours (24), l'extension longitudinale (L) étant la longueur de la ligne de parcours (24) le long de son tracé.

2. Générateur d'impulsions (2) selon la revendication 1,
**caractérisé en ce que**
la ligne de parcours (24) se situe dans un plan (42).

3. Générateur d'impulsions (2) selon l'une des revendications 1 à 2,
**caractérisé en ce que**
la ligne de parcours (24) suit une forme annulaire (40).

4. Générateur d'impulsions (2) selon l'une des revendications 1 à 2,
**caractérisé en ce que**
la ligne de parcours (24) suit au moins une forme en S simple (44).

5. Générateur d'impulsions (2) selon l'une des revendications 3 ou 4,
**caractérisé en ce que**
la ligne de parcours (24) est une ligne en zigzag (66) qui s'étend le long d'une forme annulaire (40) ou d'une forme en S (44).

6. Générateur d'impulsions (2) selon l'une des revendications 1 à 5,
**caractérisé en ce que**
la ligne de parcours (24) s'étend au moins partiellement autour du résonateur DS (8).

7. Générateur d'impulsions (2) selon l'une des revendications 1 à 5,
**caractérisé en ce que**
la ligne de parcours (24) s'étend à côté du résonateur DS (8), les extrémités (26a, b) de la ligne de parcours (24) étant adjacentes au résonateur DS (8).

8. Générateur d'impulsions (2) selon l'une des revendications précédentes,
**caractérisé en ce que**
le résonateur DS (8) s'étend, quant à sa forme, le long d'un axe longitudinal (50) et les condensateurs (16) s'étendent entre leurs deux contacts positifs (52a) et contacts négatifs (52b) respectifs parallèlement à l'axe longitudinal (50).

9. Générateur d'impulsions (2) selon l'une des revendications précédentes,
**caractérisé en ce que**
le générateur d'impulsions (2) comporte un boîtier (54) et le générateur de Marx (6), au moins en ce qui concerne ses pôles de sortie (28a, b), et le résonateur DS (8), au moins en ce qui concerne ses pôles d'entrée (30a, b), ainsi que l'ensemble des lignes d'alimentation (32a, b), sont logés à l'intérieur du boîtier commun (54)

10. Générateur d'impulsions (2) selon la revendication 9,
**caractérisé en ce que**
le générateur de Marx (6) est entièrement logé à l'intérieur du boîtier (54), mais le résonateur DS (8) n'y est logé que par une partie (64) comportant les entrées (30a, b).

11. Générateur d'impulsions (2) selon l'une des revendications 9 à 10,
**caractérisé en ce que**
le boîtier (54) est un boîtier électriquement conducteur.

12. Générateur d'impulsions (2) selon l'une des revendications 9 à 11,
**caractérisé en ce que**
le boîtier (54) est rempli d'un gaz d'isolation (62).
